# EUROPÄISCHE PATENTSCHRIFT

(11) **EP 2 768 711 B1**
(45) Veröffentlichungstag und Bekanntmachung des Hinweises auf die Patenterteilung: **26.07.2017**
(21) Anmeldenummer: 12790801.0
(22) Anmeldetag: 19.10.2012
(51) Int. Cl.: B62D 1/04, B62D 1/06, G01L 1/14, G01L 5/22, G01L 1/26, G01R 27/26, B60N 2/00

(54) **SENSORSYSTEM FÜR EIN KRAFTFAHRZEUG**
SENSOR SYSTEM FOR A MOTOR VEHICLE
SYSTÈME DE CAPTEUR POUR UN VÉHICULE AUTOMOBILE

(30) Priorität: 20.10.2011 DE 102011084903
(43) Veröffentlichungstag der Anmeldung: 27.08.2014
(73) Patentinhaber: Takata AG, 63743 Aschaffenburg (DE)
(72) Erfinder: KANDLER, Marcus, 63739 Asschaffenburg (DE); KRETZSCHMAR, Albrecht, 65618 Niederselters (DE)
(74) Vertreter: Maikowski & Ninnemann Patentanwälte Partnerschaft mbB
(86) Internationale Anmeldenummer: PCT/EP2012/070777
(87) Internationale Veröffentlichungsnummer: WO 2013/057263

(56) Entgegenhaltungen:
- DE-A1-102009 055 424
- DE-A1-102009 058 138
- DE-U1- 20 309 877

## Beschreibung

Die Erfindung betrifft ein Sensorsystem für ein Kraftfahrzeug.

Aus der DE 10 2009 055 424 A1 ist es bekannt, in eine Fahrzeugkomponente wie z.B. den Lenkradkranz eines Fahrzeuglenkrads oder die Sensormatte eines Fahrzeugsitzes ein kapazitives Sensorelement zu integrieren, das an eine Auswerteinheit angeschlossen ist, die mindestens eine Messgröße in Abhängigkeit von der kapazitiven Ankopplung des kapazitiven Sensorelementes an die Umgebung erfasst und auswertet. Um einen definierten Abstand zwischen dem Sensorelement und einem elektrischen Heizelement bereitzustellen, ist das kapazitive Sensorelement als Außenleiter ausgeführt, das ein in Form eines Innenleiters gebildetes elektrisches Heizelement umgibt.

Weitere Anordnungen, bei denen ein Sensorelement in den Lenkradkranz eines Fahrzeuglenkrad integriert ist, sind aus der DE 10 2006 031 207 B3 und der DE 10 2007 024 141 A1 bekannt.
Die DE 10 2009 058 138 A1 beschreibt die Merkmale des Oberbegriffs des unabhängigen Anspruchs 1. Bei der Integration sowohl eines Heizelementes als auch eines kapazitiven Sensorelementes in eine Fahrzeugkomponente wie z.B. einen Lenkradkranz oder eine Sensormatte ist es anzustreben, eine gegenseitige kapazitive Beeinflussung von Heizelement und kapazitivem Sensorelement zu vermeiden oder zumindest zu minimieren. Ein Problem stellt dabei der Umstand dar, dass parasitäre Kapazitäten zwischen einem kapazitiven Sensorelement und einem Heizdraht eines Heizelementes sich in Abhängigkeit von der Temperatur des Heizdrahtes verändern und dadurch nicht zu kontrollieren sind.

Der vorliegenden Erfindung liegt dementsprechend die Aufgabe zugrunde, ein Sensorsystem mit einem kapazitiven Sensorelement bereitzustellen, das eine Störbeeinflussung eines kapazitiven Sensorelements durch parasitäre Kapazitäten vermeidet oder minimiert.

Diese Aufgabe wird erfindungsgemäß durch ein Sensorsystem mit den Merkmalen des Anspruchs 1 gelöst. Ausgestaltungen der Erfindung sind in den abhängigen Ansprüchen angegeben.

Die Erfindung zeichnet sich durch ein Sensorsystem aus, das ein flächig ausgebildetes Schirmungselement und mindestens ein kapazitives Sensorelement mit einer elektrisch leitenden Struktur aufweist. Dabei weist das Sensorelement als elektrisch leitende Struktur mindestens einen Sensorleiter auf, der einen Nähfaden bildet und auf die eine Seite des Schirmungselements aufgenäht ist.

Gemäß der Erfindung erfolgt durch das Schirmungselement eine Abschirmung gegenüber parasitären Kapazitäten, wobei ein Heizelement nicht zwingend vorgesehen ist. Durch Ausbildung des Sensorleiters als Nähfaden kann ein unmittelbares Einnähen des Sensorleiters in das Schirmungselement erfolgen, was eine einfache und dabei sichere Anordnung des Sensorleiters erlaubt.

In einer Ausgestaltung der Erfindung ist vorgesehen, dass das Schirmungselement nicht aus nur einer Schicht besteht, sondern mehrere miteinander verbundene Schichten aus unterschiedlichen Materialien aufweist. Dabei ist mindestens eine der Schichten elektrisch leitfähig und mit einem elektrischen Potential beaufschlagbar. Beispielsweise kann vorgesehen sein, dass das Schirmungselement zusätzlich zu einer Schicht, die elektrisch leitfähig und mit einem elektrischen Potential beaufschlagbar ist, mindestens eine weitere Schicht aufweist, die aus einem klebbaren Material, einem Schaummaterial oder einem Vlies besteht.

Weiter kann vorgesehen sein, dass das Schirmungselement ein Gewebe aus Metallfäden aufweist, das eine Schicht des Schirmungselements oder dieses insgesamt bildet. Ein Sensorleiter und ein Heizleiter sind auf den beiden Seiten eines solchen Metallgewebes in der beschriebenen Art aufgenäht. Dabei kann vorgesehen sein, dass sowohl der Heizleiter als auch der Sensorleiter mit einer Isolierung, beispielsweise einer Lackisolierung versehen sind.

In einer weiteren Ausgestaltung der Erfindung ist vorgesehen, dass das Sensorsystem eine Schaltungsanordnung umfasst, die das Schirmungselement auf das gleiche Potential treibt wie das Sensorelement. Dies kann beispielsweise mittels eines Operationsverstärkers erfolgen. Ein Ausführungsbeispiel hierzu sieht vor, dass das Schirmungselement mit einem Spannungssignal beaufschlagt wird, das die gleiche Phase aufweist wie ein Meßsignal, mit dem das Sensorelement beaufschlagt wird. Dabei kann vorgesehen sein, dass das Spannungssignal, mit dem das Schirmungselement beaufschlagt wird, durch die gleiche Schaltungsbaugruppe bereitgestellt wird, die auch das Meßsignal bereitstellt. Dies ist mit dem Vorteil verbunden, dass in einfacher Weise eine Gleichphasigkeit der Signale bzw. Spannungen bereitgestellt werden kann. Auch kann vorgesehen sein, dass das Schirmungselement direkt mit dem Meßsignal für das Sensorelement beaufschlagt wird, dieses also zusätzlich der Bereitstellung eines definierten Potentials am Schirmungselement dient.

Durch Treiben des Schirmungselementes durch eine Schaltungsanordnung aktiv auf ein bestimmtes Potential wird ein "aktives Schild" gegen parasitäre Kapazitäten bereitgestellt. Als parasitäre Kapazitäten werden dabei solche Kapazitäten bezeichnet, die die Messung der Kapazität des kapazitiven Sensorelementes in nicht gewünschter Weise beeinflussen, beispielsweise die Kapazität eines Heizungsdrahts eines Heizungselementes oder die Kapazität eines Lenkradskeletts. Durch die Verwendung einer Verstärkerschaltung, die das Schirmungselement auf das elektrisch gleiche Potential wie den Sensor bzw. die durch den Sensor bereitgestellte Elektrode legt, wird eine Kapazität zwischen dem Schirmelement und dem kapazitiven Sensor im Idealfall vollständig unterdrückt. Im Idealfall bleibt somit allein die Änderung der zu messenden Kapazität übrig.

Es wird aber darauf hingewiesen, dass es erfindungsgemäß nicht zwingend ist, dass das Schirmelement aktiv auf das gleiche Potential wie das Sensorelement getrieben wird. Zum einen kann alternativ vorgesehen sein, dass das Schirmungselement auf ein anderes Potential getrieben wird als das Potential des Sensorelementes. So lange das Schirmungselement ein definiertes Potential besitzt, können Unterschiede zum Potential des kapazitiven Sensorelementes über ein Messoffset ausgeglichen werden. Zum anderen kann alternativ davon abgesehen werden, das Schirmungselement aktiv auf ein bestimmtes Potential zu treiben, und lediglich vorgesehen sein, das Schirmungselement leitend mit einem bestimmten festen oder variablen Potential elektrisch zu verbinden. Auch in diesem Fall stellt das Schirmungselement einen effektiven Schutz gegen parasitäre Kapazitäten bereit.

Das erfindungsgemäße Sensorsystem ist beispielsweise in einen Lenkradkranz eines Fahrzeuglenkrads integriert. Dabei ist beispielsweise vorgesehen, dass ein Schirmungselement, ein Heizelement und ein Sensorelement in koaxialer Anordnung im Lenkradkranz ausgebildet sind, also in übereinander angeordneten Schichten bzw. Ebenen.

Eine weitere Ausgestaltung der Erfindung sieht vor, dass ein erfindungsgemäßes Sensorsystem in einen Fahrzeugsitz integriert ist. Eine solche Integration erfolgt beispielsweise in eine Sensormatte, die zwischen einem Sitzpolster und einem Sitzbezug angeordnet ist. Das Schirmungselement, mindestens ein Heizelement und mindestens ein kapazitives Sensorelement sind dabei beispielsweise in planarer Anordnung in unterschiedlichen Ebenen in der Sensormatte realisiert.

Gemäß eines weiteren, unabhängigen Erfindungsaspektes weist ein Sensorsystem ein flächig ausgebildetes Schirmungselement auf, das elektrisch leitfähig und mit einem elektrischen Potential beaufschlagbar ist. Mindestens ein Heizelement ist auf einer ersten Seite des Schirmungselementes angeordnet und mindestens ein kapazitives Sensorelement, das eine elektrisch leitende Struktur aufweist, ist auf einer zweiten Seite des Schirmungselementes angeordnet.

Durch die Bereitstellung eines flächig ausgebildeten Schirmungselementes zwischen einem Heizelement und einem kapazitiven Sensorelement werden das Heizelement und das Sensorelement kapazitiv entkoppelt. Insbesondere wird weitestgehend verhindert, dass das kapazitive Feld des kapazitiven Sensorelementes durch das Heizelement und insbesondere dessen temperaturabhängige parasitäre Kapazität beeinflusst wird.

Das Heizelement wird vielmehr durch das Schirmungselement in kapazitiver Hinsicht ausgeblendet. Dieses Ausblenden von Kapazitäten und damit verbundenen Störungen im Feld des kapazitiven Sensorelements kann neben dem Ausblenden der Kapazität des Heizelements und das Ausblenden der Kapazität weiterer metallischer Gegenstände wie beispielsweise das Ausblenden der Kapazität eines Lenkradskeletts umfassen, sofern solche weiteren metallischen Gegenstände ebenfalls aus Sicht des kapazitiven Sensorelements hinter dem Schirmungselement liegen.

Die elektrisch leitende Struktur des kapazitiven Sensorelements des erfindungsgemäßen Sensorsystems bildet eine Elektrode, die an eine Auswerteinheit anschließbar ist. Die Auswerteinheit misst mindestens eine Messgröße, die von der kapazitiven Ankopplung des kapazitiven Sensorelementes bzw. der durch diese bereitgestellten Elektrode an die Umgebung abhängt. Dabei kann vorgesehen sein, dass die Kapazität der durch das kapazitive Sensorelement gebildeten Elektrode gegenüber einem Referenzpotential gemessen wird, das durch Fahrzeugkomponenten wie beispielsweise die Fahrzeugkarosserie oder Komponenten eines Fahrzeugsitzes bereitgestellt wird. Solche Fahrzeugkomponenten stellen eine fiktive zweite Elektrode dar, zu der die Kapazität gemessen wird. Bekanntermaßen hänge die Kapazität dabei von der Dielektrizitätszahl des Mediums ab, das sich zwischen den beiden Elektroden bzw. zwischen der Elektrode des kapazitiven Sensorelementes und dem Referenzpotential befindet. Da auch der menschliche Körper dielektrische Eigenschaften besitzt, ändert sich bei Annäherung des menschlichen Körpers bzw. eines Körperteils an den kapazitiven Sensor dessen Kapazität, was durch die angeschlossene Auswerteeinheit erfasst wird. Wenn beispielsweise die Hand eines Fahrers ein Lenkrad berührt, in das ein erfindungsgemäßes Sensorsystem integriert ist, so erfolgt aufgrund der damit verbundenen Änderung der Dielektrizitätszahl im Umfeld des kapazitiven Sensors eine Kapazitätsänderung, die erfasst und ausgewertet wird.

Auf diese Weise kann mittels des kapazitiven Sensors die Anwesenheit einer menschlichen Person oder eines Körperteils in der Nähe oder an einer betrachteten Fahrzeugkomponente erfasst werden, in die der Sensor integriert ist. Das erfindungsgemäße Sensorsystem ermöglicht allgemein die Erkennung der Anwesenheit von Fahrzeuginsassen oder von Körperteilen von Fahrzeuginsassen in definierten Regionen.

Zur Erfassung einer Änderung der Kapazität eines kapazitiven Sensorelementes durch eine Auswerteeinheit sind verschiedene Messverfahren möglich. Beispielsweise ist vorgesehen, dass die Kapazität des kapazitiven Sensorelementes Teil eines Schwingkreises ist, dessen Resonanzfrequenz und/oder Phase und/oder Schwingungsamplitude sich bei einer Änderung der Kapazität ändern. Gemäß einem anderen Ausführungsbeispiel beaufschlagt eine Auswerteeinheit den kapazitiven Sensor mit einem modulierten Messsignal. Hierbei handelt es sich beispielsweise um einen Wechselstrom oder um eine Wechselspannung, die mit einer bestimmten Frequenz, die niederfrequent oder hochfrequent sein kann, dem kapazitiven Sensorelement und dessen leitfähiger Struktur zugeführt wird. Eine Änderung der Kapazität wird dadurch erfasst, dass eine Änderung der Phase und/oder der Amplitude eines solchen Messsignals ausgewertet wird.

Der Wechselstrom oder die Wechselspannung ist dabei beispielsweise niederfrequent ausgebildet und weist beispielsweise eine Frequenz zwischen 80 Hz und 150 Hz, beispielsweise von 120 Hz auf. Grundsätzlich können jedoch auch andere und höhere Frequenzen eingesetzt werden.

Die erfindungsgemäße Lösung weist den weiteren Vorteil auf, dass sie eine Anordnung bereitstellt, die optisch befriedigend ist und insbesondere vermeidet, dass sich Heizelement und/oder Sensorelement gegenüber einer angrenzenden Fläche wie beispielsweise einer Lenkradlederoberfläche abzeichnen. So sieht die erfindungsgemäße Lösung ein flächig ausgebildetes Schirmungselement vor, auf dessen beiden Seiten das Heizelement und das kapazitive Sensorelement integriert sind. Heizelement und Sensorelement liegen damit in unterschiedlichen Ebenen, was Platzprobleme vermeidet. Durch die Möglichkeit der Einbettung des außen liegenden Elementes (Heizelement oder kapazitives Sensorelement) in das Schirmungselement kann ein Abzeichnen nach außen, z. B. auf einer Lenkradoberfläche vermieden werden.

Ein weiterer Vorteil der erfindungsgemäßen Lösung besteht darin, dass durch die Integration sowohl eines Heizelementes als auch eines kapazitiven Sensorelementes in ein flächig ausgebildetes Schirmungselement ein leicht handhabbares und in eine Fahrzeugkomponente zu integrierendes Sensorsystem bereitgestellt wird.

In einer Ausgestaltung der Erfindung weist das Heizelement mindestens einen Heizleiter auf, der auf die eine Seite des Schirmungselementes aufgenäht ist. Dieses Aufnähen kann zum einen dadurch erfolgen, dass der Heizleiter selbst einen Nähfaden in dem Sinne bildet, dass er mit dem Schirmungselement und/oder mindestens einem weiteren Faden oder Draht verschlungen ist. Zum anderen kann ein Aufnähen des Heizleiters auf die eine Seite des Schirmungselementes dadurch erfolgen, dass ein zusätzlicher Haltefaden verwendet wird. Mittels eines solchen zusätzlichen Haltefadens ist der Heizleiter auf die eine Seite des Schirmungselementes aufgenäht, wobei der Haltefaden den Heizfaden auf der betrachteten Seite des Schirmungselementes fixiert.

Dabei kann vorgesehen sein, dass der Haltefaden aus einem nicht leitenden Material besteht. Dies kann insbesondere dann von Vorteil sein, wenn der Haltefaden mit einem Sensorleiter - wie weiter unten noch erläutert werden wird - eine Naht bildet, wobei Sensorleiter und Haltefaden Oberfaden und Unterfaden der Naht bilden. Grundsätzlich kann jedoch ebenfalls vorgesehen sein, dass der Haltefaden durch einen elektrisch leitenden Draht gebildet wird. Ein solcher elektrisch leitender Draht kann beispielsweise einen Sensordraht oder einen Heizdraht eines weiteren Sensors oder eines weiteren Heizkreises bilden.

Der Sensorleiter kann grundsätzlich ein beliebiges ein- oder mehrteiliges elektrisch leitfähiges Element sein, z. B. ein Draht, ein Flachleiter oder ein einen aus einem leitfähigen Kunststoff gebildeten Faden oder Geflecht.

In einer Ausgestaltung ist vorgesehen, dass sowohl das Heizelement als auch der kapazitive Sensor jeweils einen Leiter in Form eines Drahtes aufweisen, der einen Nähfaden bildet, wobei der eine Nähfaden auf der einen Seite des flächig ausgebildeten Schirmungselementes und der andere Nähfaden auf der anderen Seite des flächig ausgebildeten Schirmungselementes angeordnet sind. Dabei kann es vorteilhaft sein, dass sich die beiden Fäden nicht berühren, um gegenseitige kapazitive Beeinflussungen zu vermeiden. Dementsprechend ist in einer Ausgestaltung vorgesehen, dass einer der beiden Nähfäden mit einem Haltefaden, der den anderen der Nähfaden auf der anderen Seite des Schirmungselementes fixiert, eine Naht bildet. Wenn beispielsweise der Heizleiter mittels eines Haltefadens auf der einen Seite des Schirmungselementes fixiert ist, so bildet dieser Haltefaden zusammen mit einem Sensorleiter auf der anderen Seite des Schirmungselementes eine Naht, wobei Sensorleiter und Haltefaden Oberfaden und Unterfaden der Naht bilden.

Sofern dagegen der Sensorleiter mittels eines Haltefadens auf der anderen Seite des Schirmungselementes aufgenäht ist, und der Heizleiter auf der einen Seite einen Nähfaden bildet, so kann vorgesehen sein, dass der Heizleiter und der Haltefaden eine Naht und dabei Oberfaden und Unterfaden der Naht bilden. Ebenfalls kann vorgesehen sein, dass sowohl der Heizleiter als auch der Sensorleiter mittels eines Haltefadens auf der jeweiligen Seite des Schirmungselementes fixiert sind, für welchen Fall die beiden Haltefäden eine Naht bilden.

In allen Fällen dient das flächig ausgebildete Schirmungselement als Trägermaterial sowohl für den Heizleiter (auf der einen Seite des Schirmungselementes) als auch für den Sensorleiter (auf der anderen Seite des Sensorelementes). Es erfolgt ein Vernähen dieser Leiter, entweder direkt oder unter Verwendung mindestens eines zusätzlichen Haltefadens.

Die Erfindung wird nachfolgend unter Bezugnahme auf die Figuren der Zeichnung anhand mehrerer Ausführungsbeispiele näher erläutert. Es zeigen:
- Fig. 1: in teilweiser geschnittener perspektivischer Ansicht schematisch den Aufbau eines Lenkradkranzes eines Fahrzeuglenkrads, wobei in den Lenkradkranz ein Schirmungselement, ein Heizelement und ein kapazitives Sensorelement integriert sind;
- Fig. 2: schematisch im Querschnitt den Lenkradkranz der Figur 1;
- Fig. 3: eine schematische Darstellung eines Ausführungsbeispiels eines Sensorsystems mit einem Schirmungselement, einem Heizelement und einem kapazitiven Sensorelement, wobei das Sensorelement als Nähfaden ausgebildet ist;
- Fig. 4A-4G: Ausführungsbeispiele von Sensoranordnungen mit einem Schirmungselement, einem Heizelement und einem kapazitiven Sensorelement, wobei unterschiedliche Schichten vorliegen, die das Schirmungselement und/oder daran angrenzende Schichten bilden;
- Fig. 5: schematisch das Funktionsprinzip eines kapazitiv arbeitenden Sensors am Beispiel eines in einen Lenkradkranz integrierten Sensors; und
- Fig. 6: eine Schaltungsanordnung zur Bereitstellung eines Meßsignals und eines Spannungssignal für ein Sensorsystem.

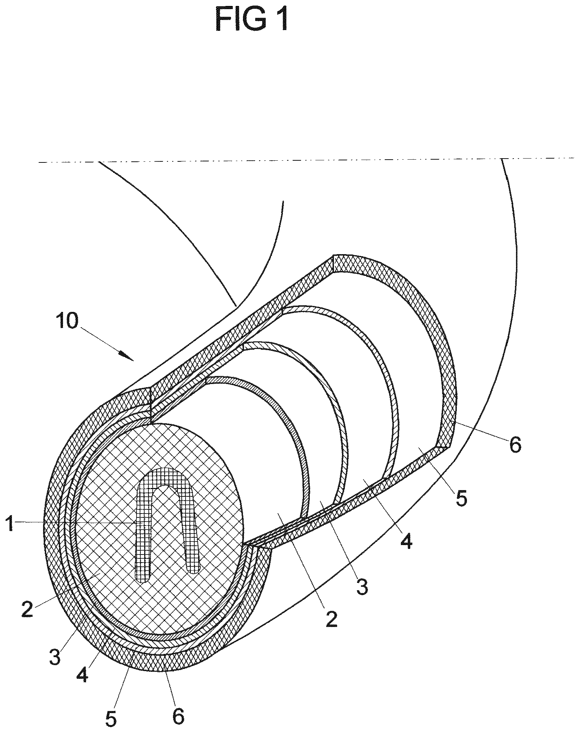

Die Figur 1 zeigt in teilweise geschnittener, perspektivischer Ansicht den Aufbau eines Lenkradkranzes 10 eines Fahrzeuglenkrads. Der Lenkradkranz 10 weist im Inneren ein metallisches Skelett 1 auf, das von einem Dielektrikum 2 umgeben ist. Das Dielektrikum 2 besteht beispielsweise aus einem geschäumten Material, beispielsweise einem Polyurethanschaum oder einem synthetischen Kautschuk. Auch kann vorgesehen sein, dass das Dielektrikum 2 aus mehreren Schichten unterschiedlichen Materials besteht. Das Dielektrikum 2 wird im Folgenden auch als Schaumschicht bezeichnet.

Die Schaumschicht 2 ist von einer Heizschicht 3 umgeben, die ein oder mehrere Heizelemente aufweist. Insbesondere umfasst die Heizschicht 3 ein elektrisch leitfähiges Material, das sich aufgrund seines ohmschen Widerstandes erwärmt, sobald eine Spannung angelegt wird. Ein solches elektrisch leitfähiges Material wird beispielsweise durch einen Heizdraht gebildet, der in der Heizschicht 3 ausgebildet ist. Im Folgenden wird zwischen der Heizschicht 3 und den in dieser ausgebildeten Heizelementen nicht unterschieden, da die Heizelemente die Heizschicht bilden.

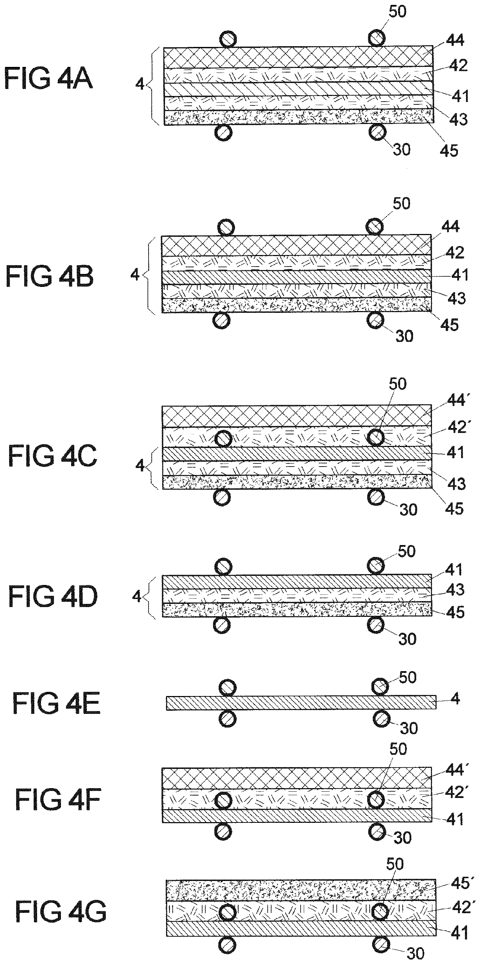

An die Heizschicht 3 schließt sich nach außen ein Schirmungselement 4 an. Das Schirmungselement 4 weist mindestens eine Schicht auf, die elektrisch leitfähig und mit einem elektrischen Potential beaufschlagbar ist, beispielsweise über ein Kontaktpad. Dabei kann vorgesehen sein, dass das Schirmungselement 4 zusätzlich zu einer solchen elektrisch leitfähigen Schicht weitere Schichten aufweist. Ausführungsbeispiele hierzu werden anhand der Figuren 4A bis 4G erläutert werden.

Das Schirmungselement 4 ist von einer Sensorschicht 5 umgeben, die mindestens ein kapazititives Sensorelement aufweist. Das kapazitive Sensorelement umfasst mindestens ein ein- oder mehrteiliges elektrisch leitfähiges Element, das im betrachteten Ausführungsbeispiel durch einen Sensordraht gebildet ist. Statt eines Sensordrahtes können jedoch auch andere leitfähige und kapazitive Eigenschaften aufweisende Elemente, wie z. B. Flachleiter oder elektrisch leitfähige Folien eingesetzt werden. Im Folgenden wird zwischen der Sensorschicht 5 und den in dieser ausgebildeten kapazitiven Sensorelementen nicht unterschieden, da die kapazitiven Sensorelemente die Sensorschicht bilden.

An die Sensorschicht 5 schließt sich ein Bezug 6 des Lenkradkranzes 10 an, der beispielsweise aus Leder besteht und die äußere Umhüllung des Lenkradkranzes 10 darstellt.

Das Heizelement 3, das Schirmungselement 4 und das Sensorelement 5 sind in koaxialer Anordnung im Lenkradkranz angeordnet und bilden aufeinanderfolgende Schichten des Lenkradkranzes 10.

Dem kapazitiven Sensorelement 5 ist eine Auswerteinheit (nicht dargestellt) zugeordnet, die die Änderung einer Messgröße, beispielsweise eines Messstroms, in Abhängigkeit von der kapazitiven Ankopplung des kapazitiven Sensorelementes an ein Referenzpotential misst. Eine solche Auswerteinheit ist beispielsweise in der DE 10 2009 055 424 A1 beschrieben, auf die insofern verwiesen wird.

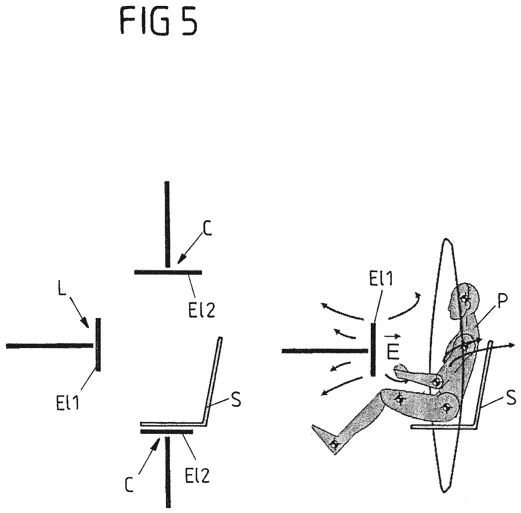

Mittels einer solchen Auswerteinheit kann erfasst werden, ob ein Fahrzeuginsasse oder ein sonstiges Objekt sich in der Umgebung des kapazitiven Sensorelementes 5 befindet. Das entsprechende Messprinzip ist schematisch in der Figur 5 dargestellt und wird anhand dieser im Folgenden erläutert.

Es sind schematisch ein Lenkrad L und ein Fahrzeugchassis C eines Kraftfahrzeugs dargestellt. Das Lenkrad L bildet eine Elektrode El1, die durch eine elektrisch leitende Struktur eines in den Lenkradkranz L integrierten kapazitiven Sensorelementes bereitgestellt wird. Das Fahrzeugchassis C bildet eine gedachte zweite Elektrode El2, die ein Referenzpotential bereitstellt, üblicherweise das Massepotential. Zwischen den Elektroden El1, El2 besteht ein elektrisches Feld E. Dessen Stärke und damit die Kapazität zwischen den Elektroden El1, El2 wird beeinflusst durch ein Dielektrikum, das sich im elektrischen Feld zwischen den Elektroden El1, El2 befindet. Ein solches Dielektrikum ist auch der menschliche Körper. Je näher der menschliche Körper dabei Elektrode El1 kommt, desto größer sind die kapazitiven Änderungen.

Wenn eine im Fahrersitz S befindliche Person P den Lenkradkranz anfasst, so dass die Hände des Fahrers in unmittelbare Umgebung der Elektrode El1 geraten, so führt dies zu einer starken Änderung der Kapazität des kapazitiven Sensorelementes. Somit kann über eine kapazitive Messung das Anliegen und Abheben einer Hand an/vom Fahrzeuglenkrad festgestellt werden (so genannte "Hands off"-Erkennung).

Das beschriebene Funktionsprinzip verdeutlicht, dass eine kapazitive Sensoranordnung zum Erfassen der Anwesenheit einer Person in entsprechender Weise beispielsweise auch in den Fahrzeugsitz S integriert sein kann, beispielsweise in Form einer Sensormatte, die sich zwischen einem Sitzbezug und einem Sitzpolster befindet. Eine andere Anwendung ist die Anordnung einer kapazitiven Sensoranordnung an einem Sicherheitsgurtsystem.

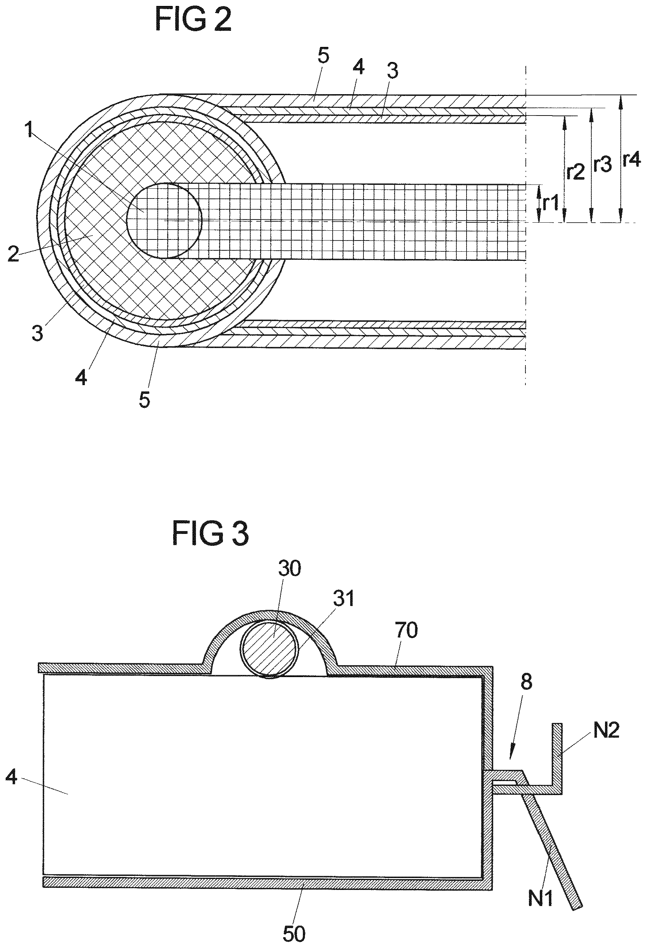

Bei einer kapazitiven Messung ist es wichtig, dass die betrachtete Elektrode des kapazitiven Sensorelementes, beispielsweise die Elektrode El1 der Figur 5, in möglichst geringem Maße mit parasitären Kapazitäten beaufschlagt wird, die eine aussagekräftige Messung erschweren oder verhindern. Solche parasitären Kapazitäten werden bei dem in der Figur 1 beschriebenen Aufbau jedoch grundsätzlich durch Kapazitäten gebildet, die zwischen dem Sensorelement 5 und dem Heizelement 3 und zwischen dem Sensorelement 5 und dem metallischen Skelett 1 ausgebildet sind. Dies wird anhand der Figur 2 im Folgenden erläutert.

Die Figur 2 zeigt in schematischer Darstellung eine Schnittansicht durch einen Lenkradkranz gemäß der Figur 1, wobei das Skelett 1 vereinfachend als im Schnitt kreisförmig und die Schichten 3, 4, 5 vereinfachend als kreisförmig dargestellt sind. Die Schicht 6 der Figur 1 ist in der Figur 2 nicht dargestellt. Ohne das elektrisch leitfähig ausgebildete Schirmungselement 4 würde eine parasitäre Kapazität zum einen zwischen dem Skelett 1 und dem Sensorelement 5 und zum anderen zwischen dem Heizelement 3 und dem Sensorelement 5 vorliegen. Diese Kapazitäten hängen in an sich bekannter Weise von der Differenz der jeweiligen Radien r1, r2, r4 und der Dieleketrizitätszahl der Schaumschicht 2 ab. Dabei ist auch zu berücksichtigen, dass sich die parasitären Kapazitäten ändern und hierdurch ein Messergebnis verfälschen können. Eine solche Änderung erfolgt beispielsweise dadurch, dass sich der Heizdraht des Heizelementes 3 bei Erwärmung ausdehnt, wodurch sich die Abstände zwischen den einzelnen Schichten ändern. Auch durch mechanische Manipulation, etwa ein Verformen der Schaumschicht 2 bei Betätigung des Lenkradkranzes durch den Fahrer, kann eine parasitäre Kapazitätsänderung erfolgen.

Durch Verwendung des elektrisch leitfähigen Schirmungselementes 4 werden diese parasitären Kapazitäten ausgeblendet. Das kapazitive Sensorelement 5 erfasst damit allein solche Kapazitätsänderungen, die mit einer gewünschten Messung zusammenhängen.

Es wird somit ein elektrisch leitfähiges Schirmungselement 4 vorgesehen, das sich zwischen dem Heizelement 3 und dem kapazitiven Sensorelement 5 befindet und das das kapazitive Sensorelement 5 gegenüber dem Heizelement 3 abschirmt. Im Ausführungsbeispiel der Figuren 1 und 2 erfolgt eine Abschirmung auch gegenüber dem Skelett 1. Allerdings sind auch Ausführungsbeispiele denkbar, bei denen das kapazitive Sensorelement 5 auf der Innenseite des Schirmungselementes 4 und das Heizelement 3 auf der Außenseite des Schirmungselementes 4 angeordnet sind, für welchen Fall durch das Schirmungselement 4 lediglich eine parasitäre Kapazität zwischen dem Heizelement 3 und dem Sensorelement 5 ausgeblendet wird.

In weiteren Ausführungsbeispielen wird von einer Heizschicht 3 bzw. Heizelementen abgesehen. Es sind für diesen Fall im Ausführungsbeispiel der Figur 1 nur die Elemente bzw. Schichten 1, 2, 4, 5, 6 vorgesehen. Das Schirmungselement 4 stellt dabei eine Abschirmung gegenüber dem Skelett 1 dar.

Zur Bereitstellung der Funktion einer kapazitiven Abschirmung ist das Schirmungselement 4 mit einem elektrischen Potential beaufschlagt. Hierbei kann es sich grundsätzlich um ein beliebiges Referenzpotential handeln. In einem Ausführungsbeispiel ist vorgesehen, dass das Schirmungselement 4 auf das gleiche Potential getrieben wird wie die elektrisch leitende Struktur des Sensorelements 5.

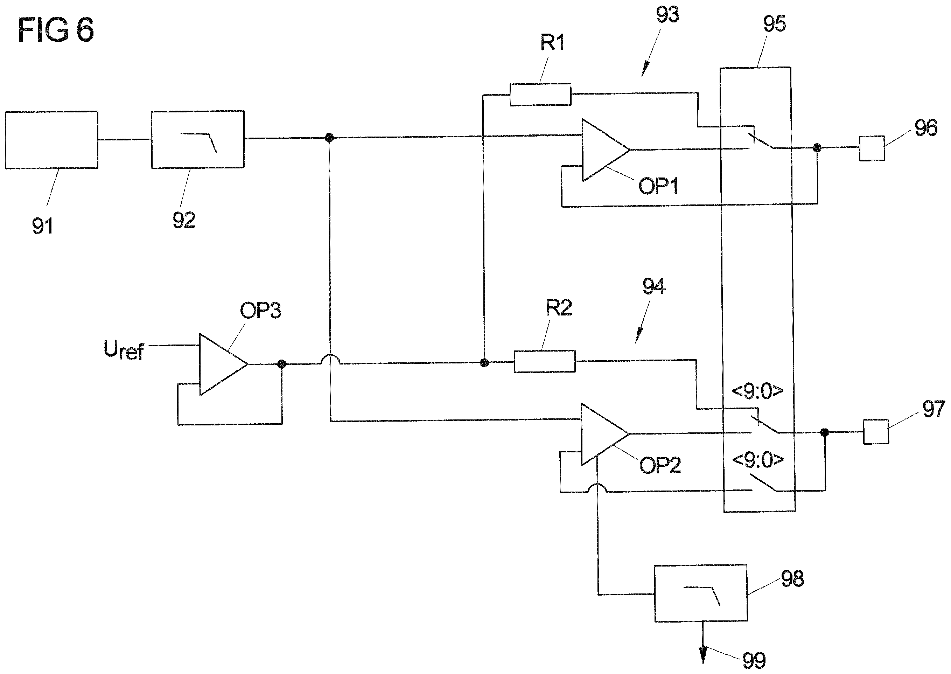

Die Figur 6 zeigt eine entsprechende Schaltungsanordnung. Die Schaltungsanordnung umfasst einen Messsignalgenerator 91, der beispielsweise ein sinusförmiges Messsignal bereitstellt. Dieses wird nach einer Tiefpassfilterung durch einen Tiefpassfilter 92 zwei Verstärkern 93, 94 zugefügt, die jeweils einen Operationsverstärker OP1, OP2 und einen Widerstand R1, R2 umfassen. Über einen weiteren Operationsverstärker OP3 wird eine Referenzspannung U_{ref} bereitgestellt. Über einen Multiplexer 95 werden an einem Kontakt 96 ein Potential für das Schirmungselement 4 und an einem Kontakt 97 ein Messsignal für das Sensorelement 5 bereitgestellt. Die Auswertung des Messsignals erfolgt, indem Änderungen des Messsignals, die auf einer Kapazitätsänderung beruhen, über einen Tiefpassfilter 98 einer weiteren Auswertung 99 zugeführt werden.

Eine Funktion der dargestellten Schaltung besteht darin, die Impedanz eines an den Kontakt 97 angeschlossenen Sensorelementes 5 zu erfassen und die erfasste Impedanz an ein Mikroprozessorsystem zu melden. Die Impedanz wird dabei beispielsweise gemessen, indem das Sensorelement 5 mit einer Sinusspannung beaufschlagt und die hierdurch ausgelöste Stromantwort gemessen wird. Änderungen in der Impedanz werden als Amplituden- und Phasenänderungen des erfassten Stroms gemessen.

Eine weitere Funktion der dargestellten Schaltung besteht in der Bereitstellung einer Spannung an dem Kontakt 96, der mit dem Schirmungselement 4 elektrisch verbunden ist. Da das Spannungssignal durch die gleiche Schaltungsbaugruppe, insbesondere den gleichen Messsignalgenerator 91 erzeugt ist wie das an dem Kontakt 97 bereitgestellte Messsignal, weisen die an den beiden Kontakten 96, 97 bereitgestellten Signale bzw. Spannungen die gleiche Phase auf. Grundsätzlich ist es jedoch ebenfalls möglich, dass ein gesonderter Schaltkreis zur Bereitstellung eines bestimmten Potentials am Kontakt 96 vorgesehen ist, auf das das Schirmungselement 4 zum Bereitstellen eines "aktiven Schilds" gegen parasitäre Kapazitäten getrieben wird. Durch die Gleichphasigkeit von beaufschlagtem Potential und Messsignal erfolgt eine besonders effektive Abschirmung des Sensorelementes 5 gegenüber parasitären Kapazitäten.

Schirmungselement 4 und Sensorelement 5 besitzen somit das gleiche elektrische Potential. Hierdurch wird eine Kapazität zwischen dem Sensorelement 5 und dem Schirmungselement 4 vollständig unterdrückt. Damit wird allein eine Kapazitätsänderung erfasst, die mit eine gewünschten Messung einhergeht, beispielsweise das Erfassen der Anwesenheit einer Person oder das Erfassen des Anliegens einer Hand einer Person an den Lenkradkranz.

Die Verbindung zwischen Schirmungselement 4, Heizelement 3 und kapazitiven Sensorelement 5 wird im Folgenden anhand mehrerer Ausführungsbeispiele erläutert. Bei diesen Ausführungsbeispielen ist ein Heizleiter des Heizelementes 3 und/oder ein Sensorleiter des kapazitiven Sensorelementes 5 als Nähfaden ausgebildet, der mit einem weiteren Faden vernäht ist. Das Schirmungselement 4 bildet dabei ein Trägermaterial für die einzelnen Fäden.

So ist gemäß der schematischen Schnittdarstellung der Figur 3 ein Sensorsystem vorgesehen, das ein flächig ausgebildetes Schirmungselement 4, einen Heizleiter 30 eines Heizelementes und einen Sensorleiter 50 eines kapazitiven Sensorelementes umfasst. Des Weiteren ist ein Haltefaden 70 aus einem nichtleitenden Material vorgesehen.

Das Schirmungselement 4 stellt ein flächig ausgebildetes Trägermaterial für den Heizleiter 30, den Sensorleiter 50 und den Haltefaden 70 bereit. Es weist mindestens eine Schicht auf, die elektrisch leitfähig und mit einem elektrischen Potential beaufschlagbar ist. Beispielsweise umfasst das Schirmungselement 4 ein Metallgewebe, das durch Kettdrähte und Schussdrähte gebildet ist.

Der Heizleiter 30 wird beispielsweise durch einen Draht gebildet, der mit einer Lackisolierung 31 ummantelt sein kann. Er wird durch den Haltefaden 70 an der einen Seite des Schirmungselementes 4 fixiert. Der Verlauf des Haltefadens 70 senkrecht zum Verlauf des Heizleiters 30 ist dabei nur schematisch und beispielhaft zu verstehen. Der Haltefaden 70 kann grundsätzlich jeden beliebigen Verlauf annehmen, der eine Fixierung des Heizleiters 30 auf der einen Seite des flächig ausgebildeten Schirmungselementes 4 erlaubt.

Auf der anderen Seite des Schirmungselementes 4 ist der Sensorleiter 50 angeordnet, der eine elektrisch leitende Struktur eines kapazitiven Sensorelementes darstellt. Der Sensorleiter 50 wird beispielsweise durch einen Draht gebildet, der mit einer Lackisolierung ummantelt sein kann. Er ist dabei als Nähfaden ausgebildet, d. h., er weist eine Dicke und Biegsamkeit derart auf, dass er in einem Nähprozess einsetzbar ist.

So ist im Ausführungsbeispiel der Figur 3 vorgesehen, dass der Sensorleiter 50 und der Haltefaden 70 zusammen eine Naht 8 bilden, wobei der Sensorleiter 50 den Unterfaden und der Haltefaden 70 den Oberfaden der Naht 8 bildet. Der Sensorleiter 50 und der Haltefaden 70 bilden dementsprechend zwei Nähfäden N1, N2 aus.

Es wird somit eine Struktur bereitgestellt, in der das Heizelement und das kapazitive Sensorelement auf unterschiedlichen Seiten eines flächig ausgebildeten Schirmungselementes 4, das als Trägermaterial dient, ausgebildet sind, wobei das Heizelement und/oder das kapazitive Sensorelement Strukturen in Form eines Nähfadens aufweisen, der mit einem weiteren Faden auf dem Trägermaterial vernähbar ist.

Die Ausgestaltung der Figur 3 ist dabei nur beispielhaft zu verstehen und kann verschiedene Abwandlungen erfahren. In einer ersten Abwandlung kann vorgesehen sein, dass der Sensordraht 50 mittels eines Haltefadens auf der einen Seite des Schirmungselementes 4 fixiert wird, während der Heizleiter auf der anderen Seite des Schirmungselementes ohne einen solche Haltefaden vorgesehen ist. In Umkehrung der Verhältnisse der Figur 3 bilden bei einer solchen Ausgestaltung der Heizfaden sowie der Haltefaden eine Naht, wobei Heizleiter und Haltefaden Ober- und Unterfaden einer Naht bilden.

Eine weitere Abwandlung kann vorsehen, dass der Haltefaden 70, der in der Figur 3 als nicht leitender Faden ausgebildet ist, ebenfalls durch einen elektrisch leitenden Draht oder anderen Leiter gebildet ist, der mit einer Isolierschicht ummantelt sein kann. Ein solcher weiterer leitender Draht kann einen Teil eines weiteren kapazitiven Sensors oder eines weiteren Heizelementes darstellen.

Eine weitere Abwandlung sieht vor, dass sowohl der Heizleiter 30 als auch der Sensorleiter 50 durch einen jeweils zugeordneten Haltefaden auf der jeweiligen Seite des Schirmungselementes 4 aufgenäht sind. Die Haltefäden sind dann beispielsweise miteinander vernäht (wobei sie Ober- und Unterfaden bilden) oder jeweils für sich mit dem Trägermaterial 4 vernäht.

Mit einer weiteren Abwandlung ist überhaupt kein Haltefaden realisiert und bilden der Heizleiter 30 und der Sensorleiter 50 selbst Ober- und Unterfaden. Dies ist allerdings mit dem Nachteil verbunden, dass aufgrund der Berührung von Oberfaden und Unterfaden bzw. Heizleiter und Sensorleiter es zu einer gegenseitigen kapazitiven Beeinflussung kommen kann, die an sich durch das Schirmungselement 4 verhindert werden soll. In einem solchen Fall könnte aber vorgesehen sein, dass der Abstand zwischen den Verbindungspunkten von Heizleiter 30 und Sensorleiter 50 groß gewählt wird, um eine gegenseitige Beeinflussung zu minimieren.

Figuren 4A bis 4G zeigen Ausführungsbeispiele für den Aufbau eines Sensorelementes entsprechend der Figur 3. Das Sensorelement ist dabei als mehrschichtiges System aufgebaut. In den Figuren 4A, 4B, 4C und 4D ist vorgesehen, dass das Schirmungselement 4 einen Mehrschichtaufbau besitzt. In den Figuren 4C, 4F, 4G ist vorgesehen, dass weitere Schichten vorhanden sind, die sich an das Schirmungselement 4 anschließen.

So zeigt die Figur 4A einen beispielhaften Schichtenaufbau, bei dem das Schirmungselement 4 aus fünft Schichten besteht, einer elektrisch leitfähigen Schicht 41 mit einem Drahtgewebe, einer darüber und einer darunter angeordneten Kleberschicht 42, 43, einer Schaumschicht 44 und einem Vlies 45. Auf den beiden Seiten des Schirmungselementes 4 sind wie in Bezug auf die Figur 3 beschrieben ein Heizleiter 30 eines Heizelementes und ein Sensorleiter 50 eines Sensorelementes angeordnet. Insbesondere durch Integration eines Vlieses in das Schirmungselement 4 als Schicht 45 wird ein sicheres Vernähen der jeweiligen Drähte 30, 50, 70 am Schirmungselement 4 erleichtert.

Das Ausführungsbeispiel der Figur 4B entspricht grundsätzlich dem Ausführungsbeispiel der Figur 4A. Jedoch ist im Ausführungsbeispiel der Figur 4B vorgesehen, dass das elektrisch leitende Drahtgewebe 41 in anderer Weise orientiert ist als im Ausführungsbeispiel der Figur 4A. Dies wird durch eine unterschiedliche Strichelung der Schicht 41 in den Figuren 4A, 4B angedeutet. So ist bei der Figur 4A vorgesehen, Kettdrähte und die Schussdrähte des Drahtgewebes rechtwinklig bzw. parallel zu den Sensordrähten 50 bzw. Heizdrähten 30 anzuordnen. Bei der Figur 4B ist vorgesehen, Kettdrähte und Schussdrähte des Drahtgewebes um einen Winkel ungleich 90°, beispielsweise von 45° gegenüber den Heizdrähten 30 und Sensordrähten 50 zu versetzen. Hierdurch wird eine erhöhte Dehnbarkeit des Gesamtelementes erreicht.

In der Figur 4C wird das Schirmungselement durch die elektrisch leitfähige Schicht 41, eine Kleberschicht 43 und ein Vlies 45 gebildet. Auf der Oberseite sind zusätzlich eine Kleberschicht 42' und eine Schaumschicht 44' ausgebildet.

Bei der Figur 4D besteht das Schirmungselement aus einer oberen elektrisch leitenden Schicht 41, einer darunter liegenden Kleberschicht 43 und einer Vliesschicht 45.

In der Figur 4E besteht das Schirmungselement 4 aus nur einer Schicht, die elektrisch leitfähig ist und beispielsweise durch ein Drahtgewebe gebildet ist.

Bei der Figur 4F ist über den Aufbau der Figur 4E eine Kleberschicht 42' und eine Schaumschicht 44' gesetzt. Bei der Figur 4G ist über den Aufbau der Figur 4E eine Kleberschicht 42' und ein Vlies 55' gesetzt.

Die Ausführungsvarianten gemäß den Figuren 4A bis 4G können realisiert sein mit einem Heizleiter 30 oder einem Sensorleiter 50 als Oberfaden oder Unterfaden und ggf. unter Verwendung eines oder mehrerer zusätzlicher Haltefäden, wie in Bezug auf die Figur 3 und die diesbezüglichen Abwandlungen beschrieben.

Eine weitere Abwandlung besteht darin, dass auf die Realisierung einer Heizschicht und Verwendung eines Heizleiters 30 verzichtet wird. Ansonsten bleibt der beschriebene Sensoraufbau der gleiche.

Die Erfindung beschränkt sich in ihrer Ausgestaltung nicht auf die vorstehend dargestellten Ausführungsbeispiele, die lediglich beispielhaft zu verstehen sind. Beispielsweise sind die verwendeten Materialien und Formen der beschriebenen elektrisch leitenden Strukturen lediglich beispielhaft zu verstehen.

## Patentansprüche

1. Sensorsystem für ein Kraftfahrzeug, das aufweist:
- ein flächig ausgebildetes Schirmungselement (4), das elektrisch leitfähig und mit einem elektrischen Potential beaufschlagbar ist, und
- mindestens ein kapazitives Sensorelement (5), das eine elektrisch leitende Struktur (50) aufweist, die auf einer Seite des Schirmungselements (4) angeordnet ist, **dadurch gekennzeichnet, dass**
- das Sensorelement (5) als elektrisch leitende Struktur (50) mindestens einen Sensorleiter (50) aufweist, der einen Nähfaden (N1) bildet und auf die eine Seite des Schirmungselements (4) aufgenäht ist.

2. Sensorsystem nach Anspruch 1, **dadurch gekennzeichnet, dass** der Sensorleiter (50) den Unterfaden (N1) oder Oberfaden einer Naht (8) bildet, die im Schirmungselement (4) ausgebildet ist.

3. Sensorsystem nach Anspruch 1 oder 2, **dadurch gekennzeichnet, dass** das Schirmungselement (4) mehrere miteinander verbundene Schichten (41-45) aus unterschiedlichen Materialen aufweist, wobei mindestens eine der Schichten (41) elektrisch leitfähig und mit einem elektrischen Potential beaufschlagbar ist.

4. Sensorsystem nach Anspruch 3, **dadurch gekennzeichnet, dass** das Schirmungselement (4) zusätzlich zu einer Schicht (41), die elektrisch leitfähig und mit einem elektrischen Potential beaufschlagbar ist, mindestens eine nichtleitende Schicht (42-45) aufweist, die beispielsweise aus einem Klebermaterial, einem Schaummaterial oder einem Fließ besteht, wobei insbesondere die Schicht (41), die elektrisch leitfähig und mit einem elektrischen Potential beaufschlagbar ist, zwischen mindestens zwei nichtleitenden Schichten (42-45) oder angrenzend an mindestens zwei nichtleitende Schichten (43, 35) des Schirmungselementes (4) im Sandwichaufbau angeordnet ist.

5. Sensorsystem nach einem der vorangehenden Ansprüche, **dadurch gekennzeichnet, dass** das Schirmungselement (4) ein Gewebe aus Metallfäden umfasst, wobei insbesondere das Schirmungselement (4) ein Drahtgewebe mit Kettdrähten und Schussdrähten aufweist, die um einen Winkel ungleich 90° gegenüber Heizleitern (30) und/oder Sensorleitern (50) versetzt sind.

6. Sensorsystem nach einem der vorangehenden Ansprüche, **dadurch gekennzeichnet, dass** zur Messung einer zu messenden Größe das Sensorelement (5) mit einem modulierten Meßsignal beaufschlagt wird und eine Änderung der Phase und/oder Amplitude des Meßsignals auswertet werden.

7. Sensorsystem nach einem der vorangehenden Ansprüche, **gekennzeichnet durch** eine Schaltungsanordnung, die das Schirmungselement (4) auf das gleiche Potential treibt wie das Sensorelement (5).

8. Sensorsystem nach den Ansprüchen 6 und 7, **dadurch gekennzeichnet, dass** das Schirmungselement (4) mit einem Spannungssignal beaufschlagt wird, das die gleiche Phase aufweist wie das Meßsignal, mit dem das Sensorelement (5) beaufschlagt wird, wobei insbesondere das Schirmungselement (4) ebenfalls mit dem Meßsignal für das Sensorelement (5) beaufschlagt wird.

9. Sensorsystem nach einem der vorangehenden Ansprüche, **dadurch gekennzeichnet, dass** Sensorsystem dazu vorgesehen und ausgebildet ist, in ein Fahrzeuglenkrad oder in einen Fahrzeugsitz integriert zu werden.

10. Sensorsystem nach einem der vorangehenden Ansprüche, **dadurch gekennzeichnet, dass** das Sensorsystem mindestens ein Heizelement (3) aufweist, das auf einer anderen Seite des Schirmungselements (4) angeordnet ist.

11. Sensorsystem nach Anspruch 10, **dadurch gekennzeichnet, dass** das Heizelement (3) mindestens einen Heizleiter (30) aufweist, der auf die andere Seite des Schirmungselements (4) aufgenäht ist.

12. Sensorsystem nach Anspruch 11, **dadurch gekennzeichnet, dass** der Heizleiter (30) selbst einen Nähfaden bildet, der mit dem Schirmungselement (4) und/oder mindestens einem weiteren Nähfaden verschlungen ist.

13. Sensorsystem nach Anspruch 11, **dadurch gekennzeichnet, dass** der Heizleiter (30) auf die andere Seite des Schirmungselements (4) mittels eines Haltefadens (70) aufgenäht ist, der den Heizleiter (30) auf der anderen Seite des Schirmungselements (4) fixiert, wobei insbesondere der Haltefaden (70) aus einem nichtleitenden Material besteht.

14. Sensorsystem nach einem der vorangehenden Ansprüche, **dadurch gekennzeichnet, dass** der Sensorleiter (50) mit mindestens einem weiteren Nähfaden (70) verschlungen ist.

15. Sensorsystem nach Anspruch 14, soweit rückbezogen auf Anspruch 13, **dadurch gekennzeichnet, dass** der Sensorleiter (50) und der Haltefaden (70) mindestens eine Naht (8) und dabei Unterfaden (N1) und Oberfaden (N2) der Naht (8) bilden.

## Claims

1. A sensor system for a motor vehicle, which includes:
- an areal shielding element (4), which is electrically conductive and to which an electric potential can be applied, and
- at least one capacitive sensor element (5), which includes an electrically conducting structure (50) which is arranged on one side of the shielding element (4),
**characterized in that**
- as electrically conducting structure (50), the sensor element (5) includes at least one sensor conductor (50) which forms a sewing thread (N1) and is sewn onto the one side of the shielding element (4).

2. The sensor system according to claim 1, **characterized in that** the sensor conductor (50) forms the bottom thread (N1) or face thread of a seam (8) which is formed in the shielding element (4).

3. The sensor system according to claim 1 or 2, **characterized in that** the shielding element (4) includes a plurality of interconnected layers (41-45) of different materials, wherein at least one of the layers (41) is electrically conductive and can be charged with an electric potential.

4. The sensor system according to claim 3, **characterized in that** in addition to a layer (41) which is electrically conductive and to which an electric potential can be applied, the shielding element (4) includes at least one non-conducting layer (42-45) which for example consists of an adhesive material, a foam material or a fleece, wherein in particular the layer (41), which is electrically conductive and to which an electric potential can be applied, is arranged between at least two non-conducting layers (42-45) or adjacent to at least two non-conducting layers (43, 35) of the shielding element (4) in a sandwich construction

5. The sensor system according to any of the preceding claims, **characterized in that** the shielding element (4) comprises a fabric of metal threads, wherein in particular the shielding element (4) includes a wire fabric with warp threads and weft threads, which are offset with respect to heating conductors (30) and/or sensor conductors (50) by an angle unequal to 90°.

6. The sensor system according to any of the preceding claims, **characterized in that** for measuring a quantity to be measured a modulated measurement signal is applied to the sensor element (5) and a change in the phase and/or amplitude of the measurement signal is evaluated.

7. The sensor system according to any of the preceding claims, **characterized by** a circuit arrangement which drives the shielding element (4) to the same potential as the sensor element (5).

8. The sensor system according to claims 6 and 7, **characterized in that** a voltage signal is applied to the shielding element (4), which has the same phase as the measurement signal which is applied to the sensor element (5), wherein in particular the measurement signal for the sensor element (5) also is applied to the shielding element (4).

9. The sensor system according to any of the preceding claims, **characterized in that** the sensor system is provided and formed to be integrated into a vehicle steering wheel or into a vehicle seat.

10. The sensor system according to any of the preceding claims, **characterized in that** the sensor system includes at least one heating element (3) which is arranged on another side of the shielding element (4).

11. The sensor system according to claim 10, **characterized in that** the heating element (3) includes at least one heating conductor (30) which is sewn onto the other side of the shielding element (4).

12. The sensor system according to claim 11, **characterized in that** the heating conductor (30) itself forms a sewing thread which is interlaced with the shielding element (4) and/or at least one further sewing thread.

13. The sensor system according to claim 11, **characterized in that** the heating conductor (30) is sewn onto the other side of the shielding element (4) by means of a holding thread (70) which fixes the heating conductor (30) on the other side of the shielding element (4), wherein in particular the holding thread (70) is made of a non-conducting material.

14. The sensor system according to any of the preceding claims, **characterized in that** the sensor conductor (50) is interlaced with at least one further sewing thread (70).

15. The sensor system according to claim 14, as far as related to claim 13, **characterized in that** the sensor conductor (50) and the holding thread (70) form at least one seam (8) and in doing so form bottom thread (N1) and face thread (N2) of the seam (8).

## Revendications

1. Système de capteur pour un véhicule automobile, comprenant :
- un élément de blindage (4) qui s'étendant dans une surface, qui est électroconducteur et auquel un potentiel électrique peut être appliqué, et
- au moins un élément capteur capacitif (5) qui présente une structure électroconductrice (50) disposée sur un côté de l'élément de blindage (4), **caractérisé en ce que**
- l'élément capteur (5) présente en tant que structure électroconductrice (50) au moins un conducteur de capteur (50) qui forme un fil de couture (N1) et est cousu sur ledit côté de l'élément de blindage (4).

2. Système de capteur selon la revendication 1, **caractérisé en ce que** le conducteur de capteur (50) forme le fil inférieur (N1) ou le fil supérieur d'une couture (8) qui est réalisée dans l'élément de blindage (4).

3. Système de capteur selon la revendication 1 ou 2, **caractérisé en ce que** l'élément de blindage (4) comporte plusieurs couches (41-45) constituées de matériaux différents et reliées les unes aux autres, dans lequel au moins l'une des couches (41) est électroconductrice et un potentiel électrique peut lui être appliqué.

4. Système de capteur selon la revendication 3, **caractérisé en ce que** l'élément de blindage (4) comporte, en plus d'une couche (41) électroconductrice à laquelle un potentiel électrique peut être appliqué, au moins une couche non conductrice (42-45) qui est par exemple constituée d'un matériau adhésif, d'un matériau en mousse ou d'un fluide, dans lequel la couche (41) électroconductrice à laquelle un potentiel électrique peut être appliqué est en particulier disposée dans une structure en sandwich entre au deux couches non conductrices (42-45) ou de manière adjacente à au moins deux couches non conductrices (43, 35) de l'élément de blindage (4).

5. Système de capteur selon l'une quelconque des revendications précédentes, **caractérisé en ce que** l'élément de blindage (4) comprend un tissu de fils métalliques, dans lequel l'élément de blindage (4) comporte en particulier un tissu de fils ayant des fils de chaîne et des fils de trame, qui est décalé d'un angle différent de 90° par rapport à des conducteurs thermiques (30) et/ou à des conducteurs de capteur (50).

6. Système de capteur selon l'une quelconque des revendications précédentes, **caractérisé en ce que**, pour mesurer une grandeur à mesurer, un signal de mesure modulé est appliqué à l'élément capteur (5) et une variation de la phase et/ou de l'amplitude du signal de mesure est analysée.

7. Système de capteur selon l'une quelconque des revendications précédentes, **caractérisé par** un dispositif à circuit qui attaque l'élément de blindage (4) au même potentiel que l'élément capteur (5).

8. Système de capteur selon les revendications 6 et 7, **caractérisé en ce qu'**un signal de tension est appliqué à l'élément de blindage (4), lequel signal de tension présente la même phase que le signal de mesure appliqué à l'élément capteur (5), dans lequel le signal de mesure destiné à l'élément capteur (5) est en particulier également appliqué à l'élément de blindage (4).

9. Système de capteur selon l'une quelconque des revendications précédentes, **caractérisé en ce que** le système de capteur est prévu et conçu pour être intégré à un volant de véhicule ou à un siège de véhicule.

10. Système de capteur selon l'une quelconque des revendications précédentes, **caractérisé en ce que** le système de capteur comporte au moins un élément chauffant (3) disposé sur un autre côté de l'élément de blindage (4).

11. Système de capteur selon la revendication 10, **caractérisé en ce que** l'élément chauffant (3) comporte au moins un conducteur thermique (30) qui est cousu sur l'autre côté de l'élément de blindage (4).

12. Système de capteur selon la revendication 11, **caractérisé en ce que** le conducteur thermique (30) forme lui-même un fil de couture qui est entrelacé dans l'élément de blindage (4) et/ou dans au moins un autre fil de couture.

13. Système de capteur selon la revendication 11, **caractérisé en ce que** le conducteur thermique (30) est cousu sur l'autre côté de l'élément de blindage (4) au moyen d'un fil de retenue (70) qui fixe le conducteur thermique (30) sur l'autre côté de l'élément de blindage (4), dans lequel le fil de retenue (70) est en particulier constitué d'un matériau non conducteur.

14. Système de capteur selon l'une quelconque des revendications précédentes, **caractérisé en ce que** le conducteur de capteur (50) est entrelacé dans au moins un autre fil de couture (70).

15. Système de capteur selon la revendication 14 lorsqu'il est fait référence à la revendication 13, **caractérisé en ce que** le conducteur de capteur (50) et le fil de retenue (70) forment au moins une couture (8) et par conséquent, un fil inférieur (N1) et un fil supérieur (N2) de la couture (8).
